# EUROPEAN PATENT APPLICATION

(11) **EP 4 712 720 A1**
(43) Date of publication of application: **18.03.2026**
(21) Application number: 25162058.9
(22) Date of filing: 06.03.2025
(51) Int. Cl.: H10B 43/50, H10B 41/27, H10B 41/50, H10B 43/27

(54) **SEMICONDUCTOR DEVICE AND METHOD OF MANUFACTURING THE SAME**

(30) Priority: 13.09.2024 JP 2024159435
(71) Applicant: Kioxia Corporation, Tokyo 108-0023 (JP)
(72) Inventor: OHASHI, Takashi, Tokyo, 108-0023 (JP)
(74) Representative: Marks & Clerk LLP

(57) **Abstract**

According to one embodiment, a semiconductor device (1) includes a first structure (LM1), a first columnar body (PL1, CC1) extending in a first direction in the first structure (LM1), a second structure (LM2), a second columnar body (PL2, CC2) extending in the first direction in the second structure (LM2), and a bonding surface (SP1) interposed between the first structure (LM1) and the second structure (LM2). The first columnar body (PL1, CC1) and the second columnar body (PL2, CC2) are connected through the bonding surface (SP1) in the first direction.

## Description

### FIELD

Embodiments described herein relate generally to a semiconductor device and a method of manufacturing the semiconductor device.

### BACKGROUND

An increase in the aspect ratio of a pattern tends to cause formation of the pattern to be difficult. Thus, a deterioration may be made in the yield of a semiconductor device.

### BRIEF DESCRIPTION OF THE DRAWINGS

Figs. 1A and 1B illustrate an exemplary schematic configuration of a semiconductor device according to an embodiment;
Figs. 2A and 2B are sectional views illustrating an exemplary detailed configuration of a memory region according to the embodiment;
Figs. 3A and 3B illustrate an exemplary detailed configuration of a step region according to the embodiment;
Figs. 4A and 4B exemplify part of the procedure of a method of manufacturing the semiconductor device according to the embodiment;
Figs. 5A and 5B exemplify part of the procedure of the method of manufacturing the semiconductor device according to the embodiment;
Figs. 6A and 6B exemplify part of the procedure of the method of manufacturing the semiconductor device according to the embodiment;
Figs. 7A and 7B exemplify part of the procedure of the method of manufacturing the semiconductor device according to the embodiment;
Fig. 8 exemplifies part of the procedure of the method of manufacturing the semiconductor device according to the embodiment;
Fig. 9 exemplifies part of the procedure of the method of manufacturing the semiconductor device according to the embodiment;
Figs. 10A to 10D exemplify part of the procedure of the method of manufacturing the semiconductor device according to the embodiment;
Figs. 11A and 11B exemplify part of the procedure of the method of manufacturing the semiconductor device according to the embodiment;
Figs. 12A and 12B exemplify part of the procedure of the method of manufacturing the semiconductor device according to the embodiment;
Figs. 13A and 13B exemplify part of the procedure of the method of manufacturing the semiconductor device according to the embodiment;
Figs. 14A and 14B exemplify part of the procedure of the method of manufacturing the semiconductor device according to the embodiment;
Fig. 15 exemplifies part of the procedure of the method of manufacturing the semiconductor device according to the embodiment;
Fig. 16 exemplifies part of the procedure of a method of manufacturing a semiconductor device according to a first modification;
Figs. 17A and 17B exemplify part of the procedure of the method of manufacturing the semiconductor device according to the first modification; and
Fig. 18 illustrates an exemplary detailed configuration of a step region according to a second modification.

### DETAILED DESCRIPTION

In general, according to one embodiment, a semiconductor device includes a first structure, a first columnar body extending in a first direction in the first structure, a second structure, a second columnar body extending in the first direction in the second structure, and a bonding surface interposed between the first structure and the second structure. The first columnar body and the second columnar body are connected through the bonding surface in the first direction.

Exemplary embodiments of a semiconductor device and a method of manufacturing the semiconductor device will be explained below in detail with reference to the accompanying drawings. The present invention is not limited to the following embodiments.

### Exemplary Configuration of Semiconductor Device

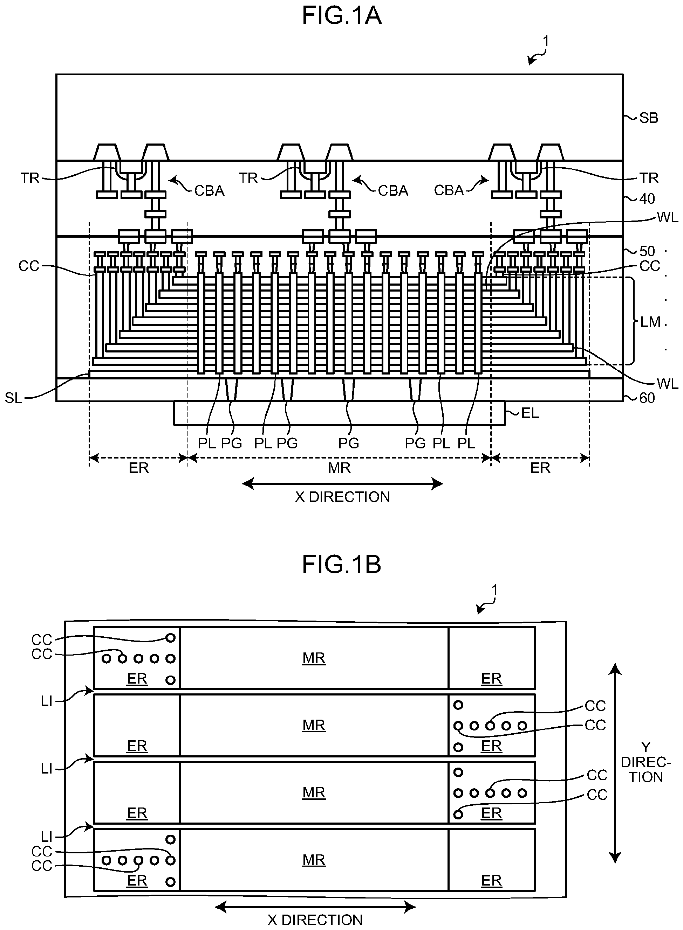

Figs. 1A and 1B illustrate exemplary schematic configuration of a semiconductor device 1 according to an embodiment. Fig. 1A illustrates a cross section along an X direction of the semiconductor device 1. Note that hatching is omitted in Fig. 1A for easy viewing of its drawing.

Herein, the faces of a plurality of word lines WL are defined as being along the X direction and a Y direction, and the X direction and the Y direction are orthogonal to each other. The direction in which each word line WL is electrically led out is also referred to as a second direction, and the second direction is along the X direction. A direction that crosses the X direction and the Y direction, namely, a direction that crosses the faces of the plurality of word lines WL is defined as a Z direction. The Z direction is an example of a first direction. In the extending direction of a contact CC, the side on which the contact CC has a contact end with a word line WL is defined as the lower side of the semiconductor device 1 and the opposite side thereto is defined as the upper side of the semiconductor device 1.

As illustrated in Fig. 1A, the semiconductor device 1 includes, in the order from bottom to top, an electrode film EL, a source line SL, and a stacked body LM including the plurality of word lines WL stacked. The semiconductor device 1 further includes a peripheral circuit CBA provided to a semiconductor substrate SB above the stacked body LM.

The source line SL is disposed on the electrode film EL through an insulating layer 60. The source line SL is, for example, a polysilicon layer.

A plurality of plugs PG is disposed in the insulating layer 60 such that the source line SL and the electrode film EL are kept in electrical connection through the plugs PG. Thus, a source potential can be applied to the source line SL from outside the semiconductor device 1 through the electrode film EL and the plugs PG.

As illustrated in Figs. 1A and 1B, the stacked body LM, which includes the plurality of word lines WL stacked, is disposed on the source line SL. A memory region MR is disposed at the center of the stacked body LM, and step regions ER are disposed at both ends of the stacked body LM. The memory region MR and the step regions ER are each divided into a plurality of regions by a plurality of plate-like contacts LI that penetrates through the stacked body LM and extends along the X direction.

A plurality of pillars PL penetrating through the word lines WL in the stack direction of the word lines WL is disposed in the memory region MR. The pillars PL each have its lower end that reaches the source line SL. A memory cell is formed at the cross portion between each pillar PL and each word line WL. Thus, the semiconductor device 1 serves, for example, as a three-dimensional nonvolatile memory including memory cells three-dimensionally disposed in the memory region MR.

A plurality of contacts CC in one-to-one connection with the plurality of word lines WL is disposed in each step region ER.

For example, a write voltage or a read voltage is applied from each contact CC to each of the corresponding memory cells included in the memory region MR at the center of the stacked body LM through the word line WL identical in height to the memory cell. As above, due to the contacts CC, the word lines WL stacked as a multilayer structure are each individually led out.

The plurality of word lines WL, the pillars PL, and the contacts CC are covered with an insulating layer 50. The insulating layer 50 expands around the plurality of word lines WL.

The semiconductor substrate SB above the insulating layer 50 is, for example, a silicon substrate. The semiconductor substrate SB has a surface on which the peripheral circuit CBA including a transistor TR and wiring is disposed. Each type of voltage to be applied from each contact CC to the corresponding memory cells is controlled by the peripheral circuit CBA electrically connected to each contact CC. As above, the peripheral circuit CBA controls the electrical operation of each memory cell.

The peripheral circuit CBA is covered with an insulating layer 40. The semiconductor device 1 including constituents, such as the plurality of word lines WL, the pillars PL, and the contacts CC, and the peripheral circuit CBA is achieved by joining the insulating layer 40 and the insulating layer 50 covering the stacked body LM.

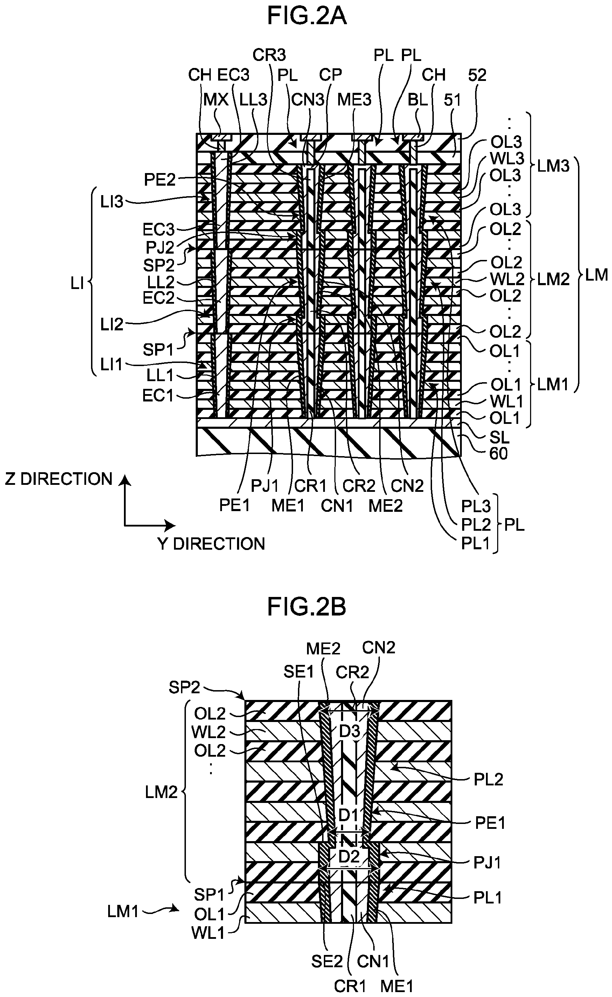

Next, an exemplary detailed configuration of the semiconductor device 1 will be described with Figs. 2A to 3B. Figs. 2A and 2B are sectional views illustrating an exemplary detailed configuration of the memory region MR according to the embodiment.

Fig. 2A is a sectional view along the Y direction of the memory region MR of the semiconductor device 1. Referring to Fig. 2A, the structure above an insulating layer 52 and the structure below an insulating layer 60 are omitted. Fig. 2B is an enlarged sectional view of a pillar PL at the height of a bonding surface SP1.

As illustrated in Fig. 2A, the stacked body LM includes a stacked body LM1, a stacked body LM2, and a stacked body LM3 that are bonded in this order from bottom. Thus, the stacked body LM has the bonding surface SP1 between the stacked body LM1 and the stacked body LM2 and a bonding surface SP2 between the stacked body LM2 and the stacked body LM3. The stacked body LM3 has an upper portion covered with an insulating layer 51 and the insulating layer 52 in this order. The insulating layer 51 and the insulating layer 52 correspond to part of the insulating layer 50 in Fig. 1.

The stacked body LM1 includes a plurality of word lines WL1 and a plurality of insulating layers OL1 alternately stacked. The uppermost layer of the stacked body LM1 is, for example, an insulating layer OL1. Note that the stacked body LM1 is an example of a first structure or a first stacked body. The word lines WL1 are each an example of a first conductive layer, and the insulating layers OL1 are each an example of a first insulating layer.

A plurality of pillars PL1 and a plate-like portion LI1 are formed in the stacked body LM1.

The plurality of pillars PL1 is substantially cylindrical in shape and extends in the Z direction in the stacked body LM1. In this case, for example, the pillars PL1 are each tapered such that its diameter decreases from its upper end to its lower end. The respective lower ends of the plurality of pillars PL1 reach the source line SL and the respective upper ends of the plurality of pillars PL1 reach the bonding surface SP1. Each of the plurality of pillars PL1 includes, in order outward from its center, a core layer CR1, a channel layer CN1 as a first semiconductor layer, and a memory film ME1. The pillars PL1 are each an example of a first columnar body or a first pillar.

The plate-like portion LI1 is formed like a plate and extends in the X and Z directions in the stacked body LM1. The plate-like portion LI1 has a lower end that reaches the source line SL and an upper end that reaches the bonding surface SP1. The plate-like portion LI1 includes a conductive portion EC1 and a liner layer LL1 disposed in order from inside. The plate-like portion LI1 is an example of a first plate-like portion.

The stacked body LM2 is bonded to the stacked body LM1 through the bonding surface SP1. The stacked body LM2 includes a plurality of word lines WL2 and a plurality of insulating layers OL2 alternately stacked. The lowermost layer of the stacked body LM2 is an insulating layer OL2. Thus, the insulating layer OL2 as the lowermost layer of the stacked body LM2 and the insulating layer OL1 as the uppermost layer of the stacked body LM1 are directly joined through the bonding surface SP1. In addition, the uppermost layer of the stacked body LM2 is an insulating layer OL2. Note that the stacked body LM2 is an example of a second structure or a second stacked body. In addition, the word lines WL2 are each an example of a second conductive layer, and the insulating layers OL2 are each an example of a second insulating layer.

A plurality of pillars PL2 and a plate-like portion LI2 are formed in the stacked body LM2.

The plurality of pillars PL2 extends in the Z direction in the stacked body LM2. The respective lower ends of the plurality of pillars PL2 are connected one-to-one to the respective upper ends of the plurality of pillars PL1 through the bonding surface SP1 in the Z direction. The respective upper ends of the plurality of pillars PL2 reaches the bonding surface SP2.

In more detail, as illustrated in Fig. 2B, the pillars PL2 each include an extending portion PE1 extending from the bonding surface SP2 to a predetermined depth of the stacked body LM2 in the Z direction and a joint portion PJ1 extending from the predetermined depth to the bonding surface SP1. The joint portion PJ1 is connected to the lower end of the extending portion PE1 through a face SE1 as a first surface and is connected to the upper end of the corresponding pillar PL1 through a face SE2 as a second surface.

The joint portion PJ1 is substantially cylindrical in shape and has a diameter D2. The extending portion PE1 is substantially cylindrical in shape and is tapered such that its diameter decreases from its upper end to its lower end. That is, the diameter D1 of the lower end of the extending portion PE1 is smaller than the diameter D3 of the upper end of the extending portion PE1. The diameter D2 of the joint portion PJ1 is not less than the diameter D1 of the lower end of the extending portion PE1 and is not more than the diameter D3 of the upper end of the extending portion PE1. The upper end of the extending portion PE1 is an example of another end.

The pillars PL2 each include, from its center, a core layer CR2, a channel layer CN2 as a second semiconductor layer, and a memory film ME2. The core layer CR2, the channel layer CN2, and the memory film ME2 are connected, respectively, to the core layer CR1, the channel layer CN1, and the memory film ME1 of the corresponding pillar PL1 through the bonding surface SP1. The pillars PL2 are each an example of a second columnar body or a second pillar.

The plate-like portion LI2 is formed like a plate and extends in the X and Z directions in the stacked body LM2. The plate-like portion LI2 has a lower end connected to the plate-like portion LI1 through the bonding surface SP1 in the Z direction and has an upper portion that reaches the bonding surface SP2. The plate-like portion LI2 includes a conductive portion EC2 and a liner layer LL2 disposed from inside. The conductive portion EC2 has a lower end connected to the conductive portion EC1 of the plate-like portion LI1 through the bonding surface SP1. The plate-like portion LI2 is an example of a second plate-like portion.

The stacked body LM2 has an upper surface to which the stacked body LM3 is bonded through the bonding surface SP2. The stacked body LM3 includes a plurality of word lines WL3 and a plurality of insulating layers OL3 alternately stacked. The lowermost layer of the stacked body LM3 is an insulating layer OL3. Thus, the insulating layer OL2 as the uppermost layer of the stacked body LM2 and the insulating layer OL3 as the lowermost layer of the stacked body LM3 are directly joined through the bonding surface SP2.

Note that the above-described word lines WL1 to WL3 are each, for example, a tungsten layer or a molybdenum layer, and the above-described insulating layers OL1 to OL3 are each, for example, an oxidized silicon layer.

A plurality of pillars PL3 and a plate-like portion LI3 are formed in the stacked body LM3.

The plurality of pillars PL3 extends in the Z direction in the stacked body LM3. The respective lower ends of the plurality of pillars PL3 are connected one-to-one to the plurality of pillars PL2 through the bonding surface SP2 in the Z direction, and the respective upper ends of the plurality of pillars PL3 penetrate through the insulating layer OL3 as the uppermost layer of the stacked body LM3 and reach the insulating layer 51.

Each of the plurality of pillars PL3 includes an extending portion PE2 extending from the insulating layer 52 to a predetermined depth of the stacked body LM3 in the Z direction and a joint portion PJ2 extending from the predetermined depth of the stacked body LM3 to the bonding surface SP2. The joint portion PJ2 and the extending portion PE2 correspond in configuration to the joint portion PJ1 and the extending portion PE1, respectively, and thus descriptions thereof will be omitted herein.

Each of the plurality of pillars PL3 includes a core layer CR3, a channel layer CN3, and a memory film ME3 from its center, and a cap layer CP on the upper side of the core layer CR3. The core layer CR3, the channel layer CN3, and the memory film ME3 are connected, respectively, to the core layer CR2, the channel layer CN2, and the memory film ME2 of the corresponding pillar PL2 through the bonding surface SP2.

The cap layer CP is connected to a bit line BL disposed in the insulating layer 52 through a plug CH disposed in the insulating layers 51 and 52. The bit line BL is connected to the corresponding transistor TR (refer to Fig. 1A) through upper wiring and a via that are not illustrated.

Note that the above-described core layers CR1 to CR3 are each, for example, oxidized silicon layer, and the above-described channel layers CN1 to CN3 and cap layer CP are each, for example, a semiconductor layer, such as a polysilicon layer or an amorphous silicon layer. The memory film ME1 includes a tunnel insulating layer, a charge storage layer, and a block insulating layer that are disposed in this order outward from the center of the corresponding pillar PL1 and are not illustrated. The memory film ME2 includes a tunnel insulating layer, a charge storage layer, and a block insulating layer that are disposed in this order outward from the center of the corresponding pillar PL2 and are not illustrated. The memory film ME3 includes a tunnel insulating layer, a charge storage layer, and a block insulating layer that are disposed in this order outward from the center of the corresponding pillar PL3 and are not illustrated. Such tunnel insulating layers and block insulating layers are each, for example, an oxidized silicon layer, and such charge storage layers are each, for example, a nitrided silicon layer.

The plate-like portion LI3 is formed like a plate and extends in the X and Z directions in the stacked body LM3. The plate-like portion LI3 has a lower end connected to the plate-like portion LI2 through the bonding surface SP2 in the Z direction and has an upper end that reaches the insulating layer 52. The plate-like portion LI3 includes a conductive portion EC3 and a liner layer LL3 disposed from inside. The conductive portion EC3 has a lower end connected to the conductive portion EC2 of the plate-like portion LI2 through the bonding surface SP2.

Note that the above-described liner layers LL1 to LL3 are each, for example, an oxidized silicon layer. In addition, the conductive portions EC1 to EC3 as conductive substances are each, for example, a tungsten layer, a nitrided tungsten layer, a titanium layer, a nitrided titanium layer, a molybdenum layer, or a nitrided molybdenum layer.

Due to mutual connection of such pillars PL1 to PL3 as described above, a pillar PL is formed. Due to mutual connection of the plate-like portions LI1 to LI3, a plate-like contact LI is formed.

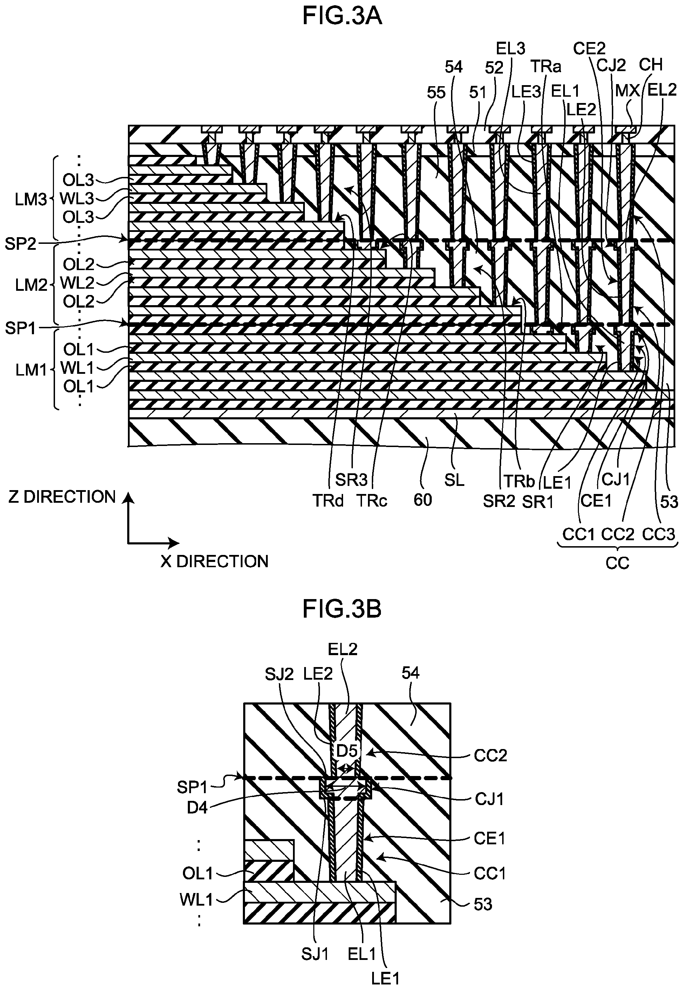

Figs. 3A and 3B illustrate an exemplary detailed configuration of a step region ER according to the embodiment.

Fig. 3A is a sectional view along the X direction of a step region ER of the semiconductor device 1. Referring to Fig. 3A, the structure above the insulating layer 52 and the structure below the insulating layer 60 are omitted. Fig. 3B is an enlarged sectional view of a contact CC at the height of the bonding surface SP1.

As illustrated in Fig. 3A, the stacked body LM1 has an end, in the X direction, at which a step portion SR1 and contacts CC1 are formed.

The step portion SR1 is formed by processing the plurality of word lines WL1 of the stacked body LM1 stepwise extending in the X direction. The step portion SR1 is covered with an insulating layer 53 ranging to the height of the uppermost insulating layer OL1, namely, ranging to the height of the bonding surface SP1. The insulating layer 53 is, for example, an oxidized silicon layer and corresponds to part of the insulating layer 50 in Fig. 1, together with the insulating layer 51 and the insulating layer 52. The insulating layer 53 is an example of a third insulating layer. The step portion SR1 is an example of a first step portion.

The contacts CC1 extend in the Z direction in the insulating layer 53. The contacts CC1 each have a lower end connected to a word line WL1 included in a step in the steps of the step portion SR1 and have an upper end that reaches the bonding surface SP1. The contacts CC1 each include, from inside to outside, a conductive layer EL1 and an insulating layer LE1. The contacts CC1 are each an example of the first columnar body or a first contact.

In more detail, as illustrated in Fig. 3B, the contacts CC1 each include a joint portion CJ1 extending from the bonding surface SP1 to a predetermined depth of the insulating layer 53 in the Z direction and an extending portion CE1 extending from the predetermined depth to the corresponding word line WL1. The joint portion CJ1 is connected to the upper end of the extending portion CE1 through a face SJ1 as a third surface and additionally is connected to the lower end of a contact CC2 described later through a face SJ2 as a fourth surface. The diameter D4 of the conductive layer EL1 formed on the joint portion CJ1 is not less than the diameter D5 of the lower end of a conductive layer EL2 of the contact CC2 described later.

The stacked body LM2 has an end, in the X direction, at which a step portion SR2 and contacts CC2 are formed.

The step portion SR2 is formed by processing the plurality of word lines WL2 of the stacked body LM2 stepwise extending in the X direction. The lowermost terrace face TRb in the respective terrace faces of the steps in the step portion SR2 is located higher step side than the uppermost terrace face TRa of the step portion SR1 is. That is, the step portion SR1 and the step portion SR2 are continuous stepwise in the X direction. The step portion SR2 is an example of a second step portion.

The step portion SR2 and the upper side of the bonding surface SP1 are covered with an insulating layer 54 ranging to the height of the uppermost insulating layer OL2, namely, ranging to the height of the bonding surface SP2. The insulating layer 54 is, for example, an oxidized silicon layer and corresponds to part of the insulating layer 50 in Fig. 1, similarly to the above-described insulating layer 53. The insulating layer 54 is an example of a fourth insulating layer.

The contacts CC2 extend in the Z direction in the insulating layer 54. Some of the contacts CC2 individually have a lower end connected to a word line WL2 included in a step in the steps of the step portion SR2 and have an upper end that reaches the bonding surface SP2. In addition, the others of the contacts CC2 individually have a lower end connected to the corresponding contact CC1 through the bonding surface SP1 in the Z direction and have an upper end that reaches the bonding surface SP2. The contacts CC2 are each an example of the second columnar body or a second contact.

The contacts CC2 each include, from inside, a conductive layer EL2 and an insulating layer LE2. The conductive layers EL2 of some of the contacts CC2 are each connected to the corresponding conductive layer EL1 through the bonding surface SP1.

The contacts CC2 each include a joint portion CJ2 extending from the bonding surface SP2 to a predetermined depth of the insulating layer 54 in the Z direction and an extending portion CE2 extending from the predetermined depth of the insulating layer 54 to the bonding surface SP1. The joint portion CJ2 and the extending portion CE2 correspond in configuration to the joint portion CJ1 and the extending portion CE1, respectively, and thus descriptions thereof will be omitted herein.

The stacked body LM3 has an end, in the X direction, at which a step portion SR3 and contacts CC3 are formed.

The step portion SR3 is formed by processing the plurality of word lines WL3 of the stacked body LM3 stepwise extending in the X direction. The lowermost terrace face TRd in the terrace faces of the step portion SR3 is located higher step side than the uppermost terrace face TRc of the step portion SR2 is. That is, the step portion SR2 and the step portion SR3 are continuous stepwise in the X direction.

The step portion SR3 and the upper side of the bonding surface SP2 are covered with an insulating layer 55 ranging to the height of the uppermost insulating layer OL3. The insulating layer 55 is, for example, an oxidized silicon layer and corresponds to part of the insulating layer 50 in Fig. 1, similarly to the above-described insulating layer 53 and insulating layer 54. As above, the insulating layers 53 to 55 are made of the same material, for example. Thus, the insulating layers 53 to 55 are substantially integrated together.

The contacts CC3 extend in the Z direction in the insulating layer 55. Some of the contacts CC3 individually have a lower end connected to a word line WL3 included in a step in the steps of the step portion SR3 and have an upper end that penetrates through the insulating layer 51 and reaches the insulating layer 52. In addition, the others of the contacts CC3 individually have a lower end connected to a contact CC2 through the bonding surface SP2 and have an upper end that penetrates through the insulating layer 51 and reaches the insulating layer 52.

The contacts CC3 each include, from inside, a conductive layer EL3 and an insulating layer LE3. The conductive layers EL3 of some of the contacts CC3 are each connected to the conductive layer EL2 of the corresponding contact CC2 through the bonding surface SP2.

The conductive layer EL3 is connected to upper layer wiring MX through a plug CH disposed in the insulating layer 52. Thus, the word lines WL1 are each electrically led out through the corresponding contacts CC1 to CC3. The word lines WL2 are each electrically led out through the corresponding contacts CC2 and CC3. The word lines WL3 are each electrically lead out through the corresponding contact CC3.

As described above, each contact CC is formed due to mutual connection of the contacts CC1 to and CC3.

Note that, referring to Figs. 2A to 3B, the stacked bodies LM1 to LM3, of which the number of layers is proper for description, are illustrated. However, the number of layers for each of the stacked bodies LM1 to LM3 is not limited to the illustrated example. The number of the plurality of word lines and the number of the plurality of insulating layers in each of the stacked bodies LM1 to LM3 may be, for example, 100 or more.

For example, in a case where a value resulting from division of the height in the Z direction of a pillar PL by the diameter of the upper end, which is a portion having a largest diameter, in the pillar PL is defined as the aspect ratio for the pillar PL and a value resulting from division of the height in the Z direction of a contact CC by the diameter of the upper end, which is a portion having a largest diameter, in the contact CC is defined as the aspect ratio for the contact CC, the respective aspect ratios for the pillar PL and the contact CC are, for example, 25 or more and 100 or less, more preferably, 50 or more and 100 or less in the present embodiment.

### Method of Manufacturing Semiconductor Device

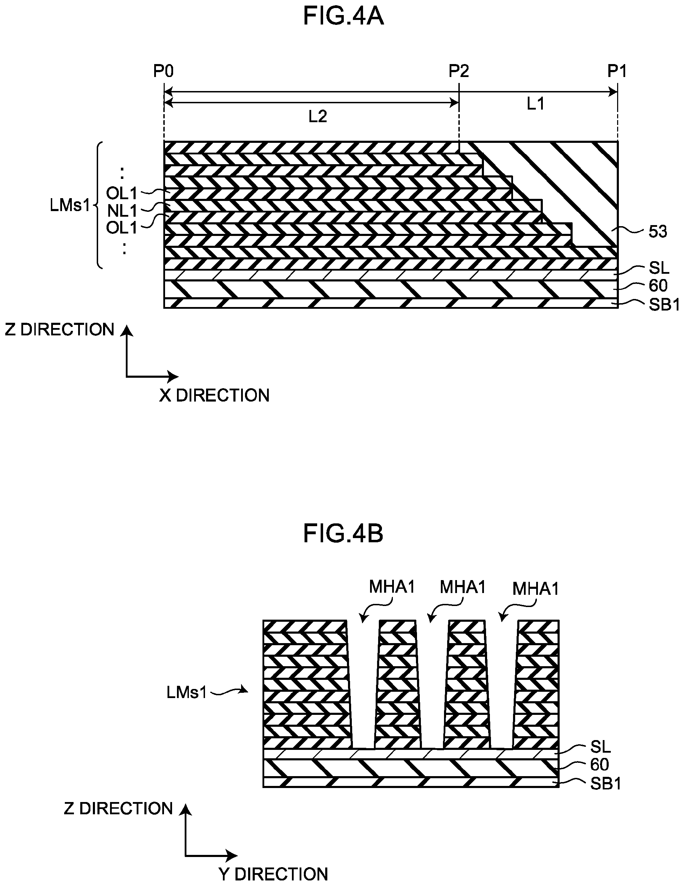

Figs. 4A to 15 each exemplify part of the procedure of a method of manufacturing the semiconductor device 1 according to the embodiment.

A process of manufacturing the semiconductor device 1 includes at least a first step of forming a stacked body LM1 on a substrate SB1, a second step of forming a stacked body LM2 on a substrate SB2, a third step of forming a stacked body LM3 on a substrate SB3, and a bonding step of bonding the substrates SB1 to SB3 together.

In addition, the first step includes at least a step of forming such pillars PL1, contacts CC1, and a plate-like portion LI1 as described above. The second step includes at least a step of forming such pillars PL2, contacts CC2, and a plate-like portion LI2 as described above. The third step includes at least a step of forming such pillars PL3, contacts CC3, and a plate-like portion LI3 as described above. The first to third steps each further include a test step of testing the shape of a formed pattern.

A flow of the first step will be described with Figs. 4A to 9.

First, a stage where a portion to be a step portion SR1 is formed on a substrate SB1 and a stage where portions to be pillars PL1 are formed on the substrate SB1 are illustrated in Figs. 4A and 4B, respectively. Fig. 4A illustrates a cross section along the X direction of a portion to be a step region ER on the substrate SB1. Fig. 4B illustrates a cross section along the Y direction of a portion to be a memory region MR on the substrate SB1.

As illustrated in Fig. 4A, an insulating layer 60 and a source line SL are formed on the substrate SB1, such as a silicon substrate. A stacked body LMs1 including a plurality of insulating layers OL1 and a plurality of sacrificial layers NL1 alternately stacked is formed on the source line SL. The substrate SB1 is an example of a first substrate.

The sacrificial layers NL1 are each, for example, a nitrided silicon layer. The sacrificial layers NL1 each function as a sacrificial layer to be replaced with a word line WL1. The sacrificial layers NL1 are each an example of the second insulating layer.

Next, due to a series of steps of forming a mask with a photoresist, etching with the mask, slimming the mask, and etching with the slimmed mask, part of the stacked body LMs1 is processed to have a step portion SR1. In this case, the step portion SR1 is formed such that each terrace face of the step portion SR1 is disposed between a position P1 at a distance L1 in the X direction from a predetermined criterial point P0 of the stacked body LMs1 and a position P2 at a distance L2 in the X direction from the predetermined criterial point P0. The position P2 is closer to the criterial point P0 than the position P1 is. Therefore, the steps of the step portion SR1 go upward from the position P1 to the position P2.

Next, an insulating layer 53, which covers the step portion SR1 and reaches the height of the uppermost insulating layer OL1, is formed.

As illustrated in Fig. 4B, the insulating layer 60, the source line SL, and the stacked body LMs1 are formed also in a region to be a memory region MR on the substrate SB1. A plurality of memory holes MHA1, which penetrates through the stacked body LMs1 in the Z direction and reaches the source line SL, is formed. The memory holes MHA1 are provided to form pillars PL1.

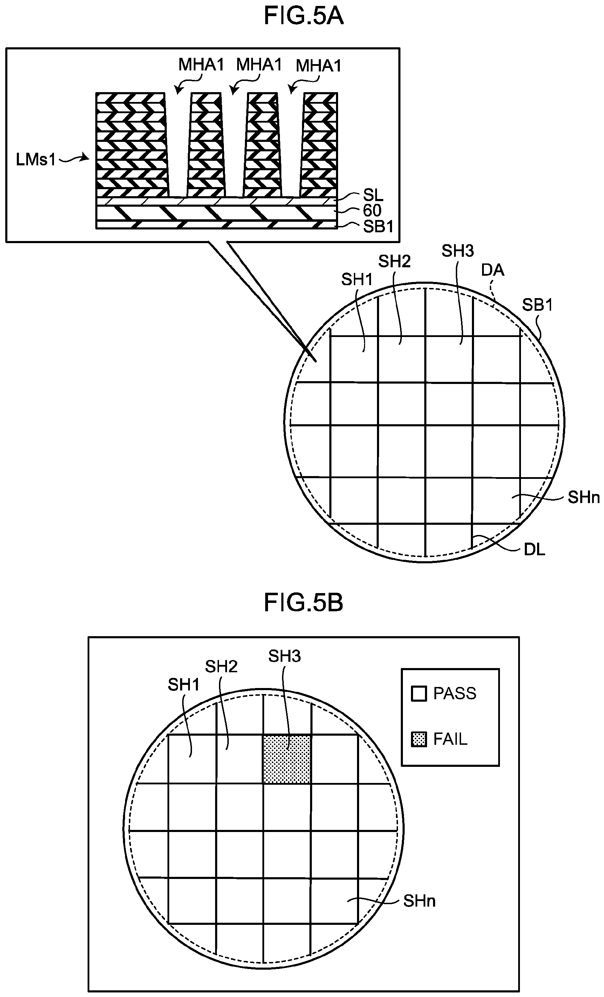

Here, a plurality of shots SH that the substrate SB1 has will be described. Fig. 5A is a plan view illustrating the state of shots formed on the substrate SB1. Fig. 5B illustrates an exemplary result of test of memory holes MHA1 formed in each shot.

As illustrated in Fig. 5A, the region excluding the outermost circumference of the substrate SB1 is an element region DA in which the above-described semiconductor device 1 is to be disposed. The element region DA is segmented into a plurality of shots SH1 to SHn by a plurality of division lines DL in mutual crossing (n is an integer of 1 or more). Each individual shot SH is an element as a unit of an individual piece of processing in the process of manufacturing the semiconductor device 1.

Due to the steps described with Figs. 4A and 4B, at least one stacked body LMs1 is formed in each of the shots SH1 to SHn. That is, at least n stacked bodies LMs1 are formed on the substrate SB1, and a plurality of memory holes MHA1 is formed in each of the n stacked bodies LMs1. At the final stage in the process of manufacturing the semiconductor device 1, the n stacked bodies LMs1 are chipped along the plurality of division lines DL as cut chips each having the semiconductor device 1 mounted thereon. Therefore, in the example of Figs. 5A and 5B, the region of each shot SH and the region of the corresponding target to be chipped as a chip are substantially identical to each other. Note that, for example, a plurality of stacked bodies LM1 may be included in the chip of one semiconductor device 1.

In a test step for the memory holes MHA1, first, the substrate SB1 is loaded into a test apparatus. As the test apparatus, for example, a critical dimension scanning electron microscope (CD-SEM) is used.

The CD-SEM acquires imaging data of the plurality of memory holes MHA1 formed on the substrate SB1 and analyzes the acquired imaging data to measure the dimensions of each memory hole MHA1. For example, based on the dimensional deviation of the plurality of memory holes MHA1, the CD-SEM determines, for each shot, whether or not each memory hole MHA1 is formed properly.

For example, in a case where the dimensional deviation of the plurality of memory holes MHA1 is more than a predetermined threshold, it is determined that the corresponding memory hole MHA1 is not formed properly in the shot, for example, the memory hole MHA1 does not penetrate through the stacked body LMs1 (fail). In a case where a memory hole MHA1 is not formed properly, a pillar PL1 is unlikely to be formed properly in the subsequent step. As a result, a memory cell is unlikely to operate properly. On the other hand, in a case where the dimensional deviation of the plurality of memory holes MHA1 is not more than the predetermined threshold, it is determined that the corresponding memory hole MHA1 is formed properly in the shot (pass).

As illustrated in Fig. 5B, the CD-SEM outputs a result of test in which results of determination and shot numbers are associated with each other. The substrate SB1 is unloaded from the test apparatus and then the test step terminates.

Note that the above-described determination processing based on the result of measurement of the dimensions of the memory holes MHA1 may be performed by an information processing apparatus different from the CD-SEM. In addition, these apparatuses may be each operated, for example, by an operator.

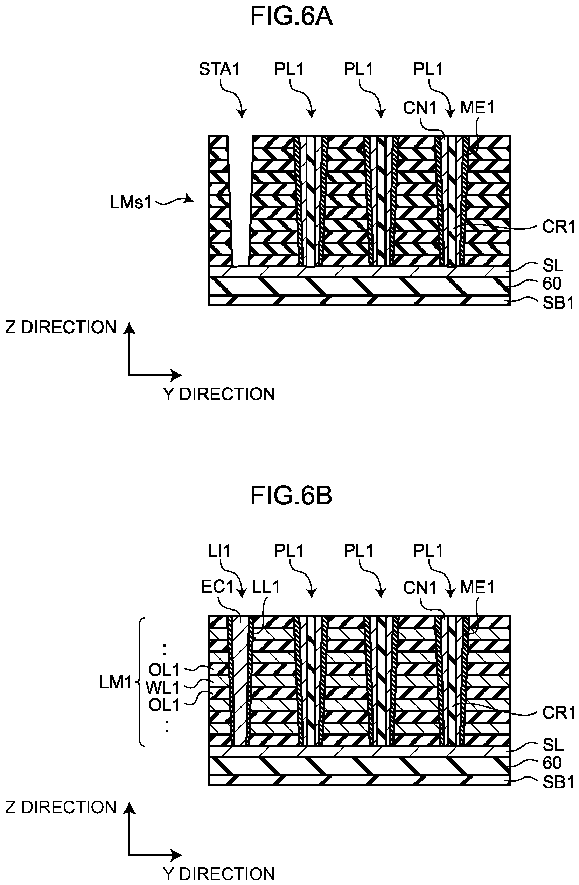

Next, a stage where a plurality of pillars PL1 is formed on the substrate SB1 after the test step and a stage where a plate-like portion LI1 is formed on the substrate SB1 after the test step are illustrated in Figs. 6A and 6B, respectively. Figs. 6A and 6B each illustrate a cross section along the Y direction of the portion to be a memory region MR on the substrate SB1.

As illustrated in Fig. 6A, a memory film ME1 and a channel layer CN1 are formed in this order inside each memory hole MHA1. Note that the memory film ME1 on the bottom of each memory hole MHA1 is removed before formation of the channel layer CN1. Thus, the channel layer CN1 is connected to the source line SL through the bottom. In addition, the gap inside the channel layer CN1 is filled with a core layer CR1. Then, a plurality of pillars PL1 is formed.

Next, a slit STA1, which penetrates through the stacked body LMs1 and reaches the source line SL, is formed. The slit STA1 also extends along the X direction in the stacked body LMs1. The slit STA1 is a portion to be a plate-like portion LI1.

Next, referring to Fig. 6B, word lines WL1 are formed at the locations of the sacrificial layers NL1 in the stacked body LMs1 to form a stacked body LM1.

Specifically, first, the sacrificial layers NL1 are removed by wet etching through the slit STA1. Thus, the sacrificial layers NL1 exposed on each side face of the slit STA1 are removed in the X direction and the Y direction, so that spaces not illustrated are each generated between the corresponding insulating layers OL1, the spaces extending on an XY plane and being disposed in layers in the Z direction. Subsequently, base gas for a conductive material, such as tungsten or molybdenum is injected into the space between each insulating layer OL1 through the slit STA1. Thus, the sacrificial layers NL1 are each replaced with a word line WL1, so that a stacked body LM1 is obtained. Hereinafter, the processing of forming a word line at the location of a sacrificial layer is also referred to as replacement processing.

Next, a liner layer LL1 is formed on each side wall of the slit STA1 and then a conductive portion EC1 is filled between the liner layers LL1 to form a plate-like portion LI1.

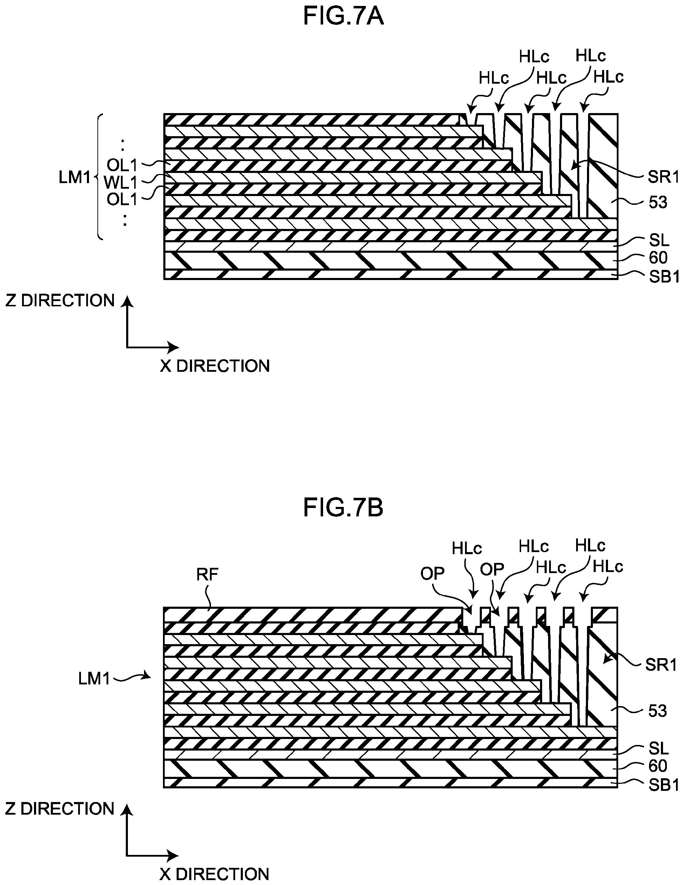

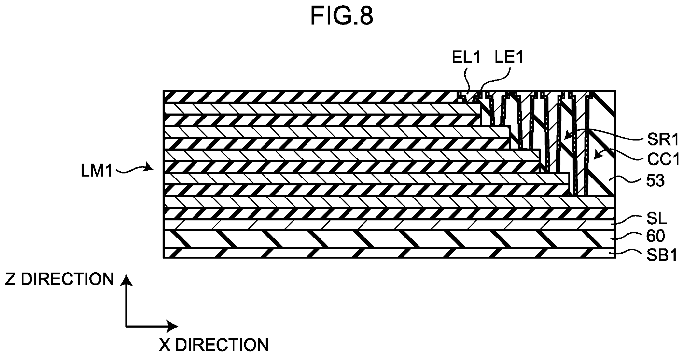

Next, stages for formation of contacts CC are illustrated in Figs. 7A to 8. Figs. 7A and 7B and Fig. 8 each illustrate a cross section along the X direction of the portion to be a step region ER on the substrate SB1.

As illustrated in Fig. 7A, due to the replacement processing described with Fig. 6B, a plurality of word lines WL1 is formed also in the step portion SR1.

A plurality of contact holes HLc, which penetrates through the insulating layer 53 and reaches one-to-one the word lines WL1, is formed. The contact holes HLc are each a portion to be a contact CC1.

Next, a photoresist film RF is applied onto the stacked body LM1 and the insulating layer 53, and then openings are made to the photoresist film RF by exposure and development such that the upper sides of the contact holes HLc are exposed. Note that, in this case, the photoresist film RF is made to have openings such that the diameter of each contact hole HLc is smaller than the diameter of an opening OP. In addition, with the photoresist film RF as a mask, dry etching is performed by a depth without penetration through the insulating layer 53. Thus, openings OP are formed for the upper ends of contacts CC1. The openings OP are each a portion to be a joint portion CJ1.

Thus, in the later bonding step, a wide allowable range can be ensured for misalignment of each contact CC2 to the upper end of the corresponding contact CC1 at the time of connection of the joint portion CJ1 of each contact CC1 with the lower end of the corresponding contact CC2. As a result, the contacts CC1 and the corresponding contacts CC2 can be connected more reliably.

Referring to Fig. 8, after the photoresist film RF is removed, the side wall of each contact hole HLc is covered with an insulating layer LE1 and then the gap inside the insulting layer LE1 in each contact hole HLc is filled with a conductive layer EL1. Then, contacts CC1 are formed.

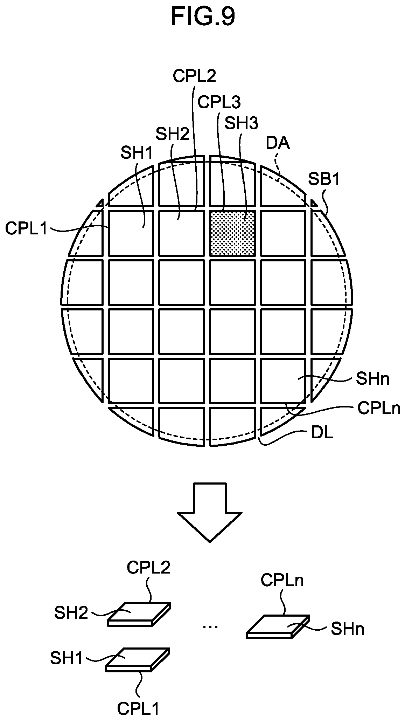

Next, a stage where the substrate SB1 is chipped into a plurality of chips each including a single stacked body LM1 and then passed chips are selected from the plurality of chips is illustrated in Fig. 9.

As illustrated in Fig. 9, the substrate SB1 is cut in the Z direction along the division lines DL. Thus, chips CPL1 to CPLn are formed. As described above, in the present embodiment, the chips CPL1 to CPLn correspond to the shots SH1 to SHn, respectively.

Based on the result of test of the memory holes MHA1 output in the test step described with Figs. 5A and 5B, a chip including a "passed" shot is selected from the chips CPL1 to CPLn. For example, in the example of Fig. 9, the chips except the chip CPL3 are passed chips. The selected passed chips are each bonded to another chip in the bonding step described later. Then, the first step terminates.

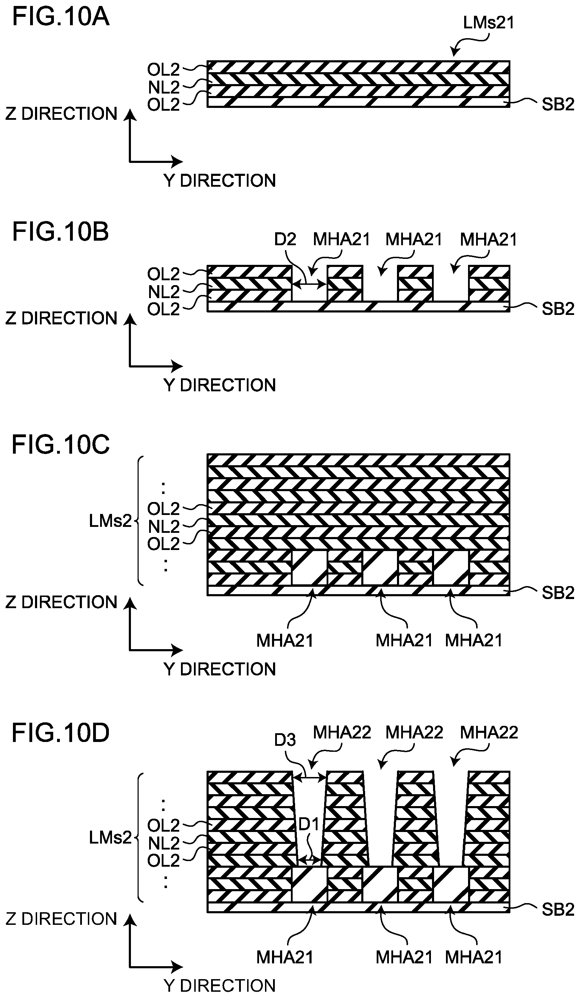

Next, a flow of the second step will be described with Figs. 10A to 12B.

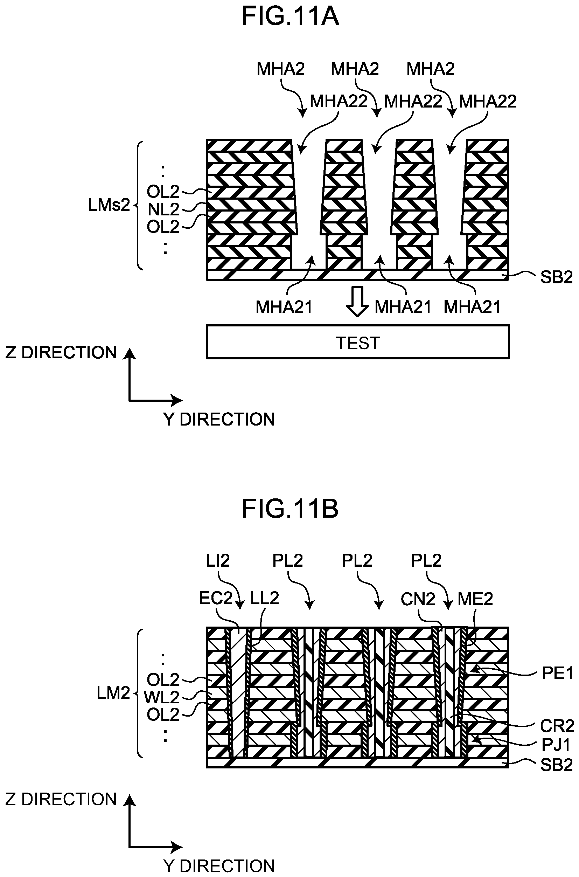

First, stages where portions to be pillars PL2 are formed on a substrate SB2 are illustrated in Figs. 10A to 10D and Figs. 11A and 11B. Figs. 10A to 10D and Figs. 11A and 11B each illustrate a cross section along the X direction of a portion to be a step region ER on the substrate SB2.

As illustrated in Fig. 10A, insulating layers OL2, the number of which is predetermined, and sacrificial layers NL2, the number of which is predetermined, are alternately stacked on the substrate SB2, such as a silicon substrate, to form a stacked body LMs21. Such a sacrificial layer NL2 is, for example, a nitrided silicon layer. The sacrificial layer NL2 functions as a sacrificial layer to be replaced with a word line WL2. The sacrificial layer NL2 is an example of the third insulating layer. The substrate SB2 is an example of a second substrate.

As illustrated in Fig. 10B, a plurality of holes MHA21, which penetrates through the stacked body LMs21 in the Z direction and reaches the substrate SB2, is formed. The holes MHA21 are each a portion to be a joint portion PJ1. Each of the plurality of holes MHA21 has a diameter D2.

As illustrated in Fig. 10C, for example, a CVD carbon layer is embedded in each hole MHA21 and then insulating layers OL2 and sacrificial layers NL2 are further stacked on the stacked body LMs21 and the CVD carbon layer. Thus, a stacked body LMs2 is formed.

Next, as illustrated in Fig. 10D, holes MHA22, which penetrate through the insulating layers OL2 and the sacrificial layers NL2 in the Z direction and reach one-to-one the respective CVD carbon layers embedded in the holes MHA21, are formed on the holes MHA21. The holes MHA22 are each a portion to be an extending portion PE2. The holes MHA22 each have an upper end having a diameter D3 and a lower end having a diameter D1 smaller than the diameter D3. That is, the holes MHA22 are each tapered such that the diameter decreases from the upper end to the lower end.

Here, the diameter D2 of each hole MHA21 is larger than the diameter D1 of the lower end of each hole MHA22. Thus, in the later bonding step, a wide allowable range can be ensured for misalignment of each pillar PL2 to the upper end of the corresponding pillar PL1 at the time of connection of the joint portion PJ1 of each pillar PL2 with the upper end of the corresponding pillar PL1. As a result, the pillars PL1 and the corresponding pillars PL2 can be connected more reliably.

In addition, the diameter D2 of each hole MHA21 is not more than the diameter D3 of the upper end of each hole MHA22. That is, the cross-sectional area of each joint portion PJ1 viewed in the Z direction is not more than the cross-sectional area of the upper end of each pillar PL2. Thus, even when the joint portions PJ1 are formed, no deterioration is made in the density of arrangement of the pillars PL2. In addition, adjacent pillars PL2 can be inhibited from interfering with each other through their joint portions PJ1.

As illustrated in Fig. 11A, the respective CVD carbon layers embedded in the holes MHA21 are removed, for example, by ashing. Thus, memory holes MHA2 are formed.

Next, the substrate SB2 is loaded into the test apparatus, and then the shapes of the plurality of memory holes MHA2 formed on the substrate SB2 are tested.

Although the illustration is omitted, an element region, which is not illustrated, in the substrate SB2 is also segmented into n shots corresponding to the shots SH1 to SHn. Due to the above-described processing in Figs. 10A to 11A, each of the plurality of shots has a stacked body LMs2 and a plurality of memory holes MHA2 formed therein.

Due to the method described with Figs. 5A and 5B, for each shot, it is determined whether or not each memory hole MHA2 is formed properly. A result of test including results of determination and shot numbers in association is output and then the substrate SB2 is unloaded from the test apparatus, followed by termination of the test step.

Next, as illustrated in Fig. 11B, a memory film ME2, a channel layer CN2, and a core layer CR2 are formed in this order inside each memory hole MHA2 on the substrate SB2 after the test step. In this case, the memory film ME2 on the bottom of each memory hole MHA2 is removed before formation of the channel layer CN2 such that the channel layer CN2 can have contact with the substrate SB2. Thus, at the time of connection with the pillars PL1 of the stacked body LM1 at a later stage, each channel layer CN2 can be connected to the channel layer CN1 of the corresponding pillar PL1. Then, a plurality of pillars PL2, which each includes a joint portion PJ1 and an extending portion PE1, is formed.

Next, a slit, which is not illustrated, penetrates through the stacked body LMs2, and reaches the substrate SB2, is formed and then a word line WL2 is formed at the location of each sacrificial layer NL2 of the stacked body LMs2 by replacement processing to form a stacked body LM2. A liner layer LL2 and a conductive portion EC2 are formed in the slit. Then, a plate-like portion LI2 is formed.

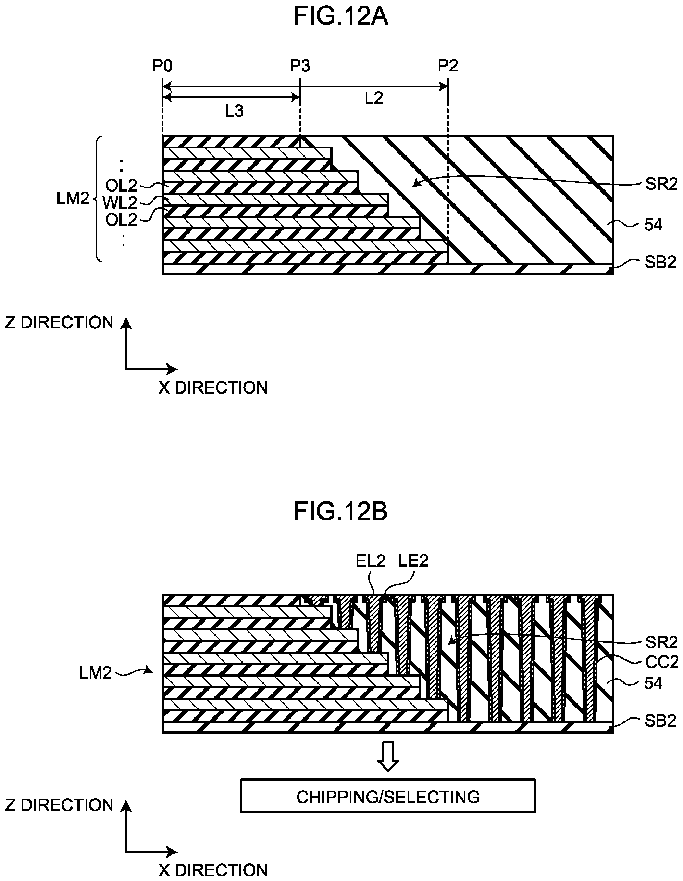

Next, a stage for formation of contacts CC2 is illustrated in Figs. 12A and 12B. Figs. 12A and 12B each illustrate a cross section along the X direction of a portion to be a step region ER on the substrate SB2.

In a region to be a step region ER on the substrate SB2, the stacked body LMs2 is formed due to the processing illustrated in Figs. 10A to 10C and, briefly describing, a step portion SR2 is formed due to processing corresponding to the processing for the step portion SR1. Next, an insulating layer 54, which reaches the height of the uppermost insulating layer OL2, is formed on the substrate SB2 and the step portion SR2. Next, due to the replacement processing in Fig. 11B, a plurality of word lines WL2 is formed as illustrated in Fig. 12A.

The step portion SR2 is formed to have terrace faces disposed between a position P2 at a distance L2 in the X direction from a predetermined criterial point P0 of the stacked body LMs2 and a position P3 at a distance L3 in the X direction from the predetermined criterial point P0. The criterial point P0 defined on the substrate SB2 is identical in position to the criterial point P0, on the substrate SB1, provided to the stacked body LMs1 in the above-described processing in Fig. 4A. The position P2 at the distance L2 from the criterial point P0 is identical to the position P2 set to the stacked body LMs1. The position P3 is closer to the criterial point P0 than the position P2 is. Therefore, the steps of the step portion SR2 go upward from the position P2 to the position P3. Thus, in a case where the stacked body LM1 and the stacked body LM2 are bonded together such that their criterial points P0 are overlapped on top of each other, the step portion SR1 and the step portion SR2 are continuous stepwise in the X direction.

Next, due to processing corresponding to the processing illustrated in Figs. 7A and 7B and Fig. 8, contacts CC2 are formed as illustrated in Fig. 12B.

Next, the substrate SB2 is polished from below until the lowermost insulating layer OL2 is exposed, and then cutting in the Z direction is performed along the division lines. Thus, n chips are formed.

Next, based on the result of test of the memory holes MHA2 output in the test step in Fig. 11A, a chip including a "passed" shot is selected from the n chips. The selected passed chip is bonded to another chip in the bonding step described later. Then, the second step terminates.

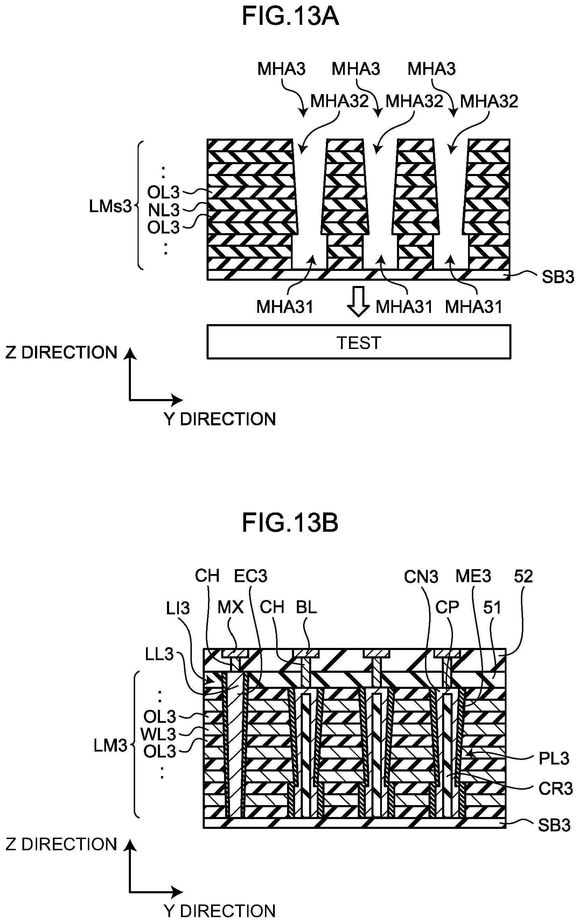

Next, a flow of the third step will be described with Figs. 13A to 14B.

First, a stage where portions to be pillars PL3 are formed on a substrate SB3 is illustrated in Fig. 13A. Fig. 13A illustrates a cross section along the X direction of a portion to be a memory region MR on the substrate SB3.

Specifically, insulating layers OL3 and sacrificial layers NL3 are alternately stacked on the substrate SB3, such as a silicon substrate, to form a stacked body LMs3. The sacrificial layers NL3 are each, for example, a nitrided silicon layer. The sacrificial layers NL3 each function as a sacrificial layer to be replaced with a word line WL3.

Due to processing corresponding to the processing in Figs. 10A to 11A, a plurality of memory holes MHA3, which penetrates through the stacked body LMs3 in the Z direction and reaches the substrate SB3, is formed.

Note that each of the plurality of memory holes MHA3 includes a hole MHA31 to be a joint portion PJ2 and a hole MHA32 to be an extending portion PE2. A method of forming holes MHA31 and holes MHA32 is similar to the method described with Figs. 10A to 10D, and thus description thereof will be omitted herein.

Next, the substrate SB3 is loaded into the test apparatus, and then the shapes of the plurality of memory holes MHA3 formed on the substrate SB3 are tested.

Although the illustration is omitted, an element region, which is not illustrated, in the substrate SB3 is also segmented into n shots corresponding to the shots SH1 to SHn of the substrate SB1. Each of the plurality of shots has a stacked body LMs3 and a plurality of memory holes MHA3 formed therein.

Due to the method described with Figs. 5A and 5B, for each shot, it is determined whether or not each memory hole MHA3 is formed properly. A result of test including results of determination and shot numbers in association is output and then the substrate SB3 is unloaded from the test apparatus, followed by termination of the test step.

Next, as illustrated in Fig. 13B, a memory film ME3, a channel layer CN3, and a core layer CR3 are formed in this order inside each memory hole MHA3 on the substrate SB3 after the test step. A cap layer CP is formed on the upper side of the core layer CR3. Then, a plurality of pillars PL3 is formed.

Next, an insulating layer 51 is formed on the stacked body LMs3 and then a slit, which is not illustrated, penetrates through the stacked body LMs3 and the insulating layer 51 in the Z direction, and reaches the substrate SB3, is formed, followed by formation of a stacked body LM3 by replacement processing. A liner layer LL3 and a conductive portion EC3 are formed in the slit. Then, a plate-like portion LI3 is formed.

An insulating layer 52 is formed on the insulating layer 51 and then plugs CH, which extend in the Z direction in the insulating layer 52 and are each connected to a cap layer CP or the conductive portion EC3, are formed. Bit lines BL, which are each connected to a pillar PL3 through the corresponding plug CH, are formed and upper layer wiring MX, which is connected to the conductive portion EC3 through the corresponding plug CH, is formed.

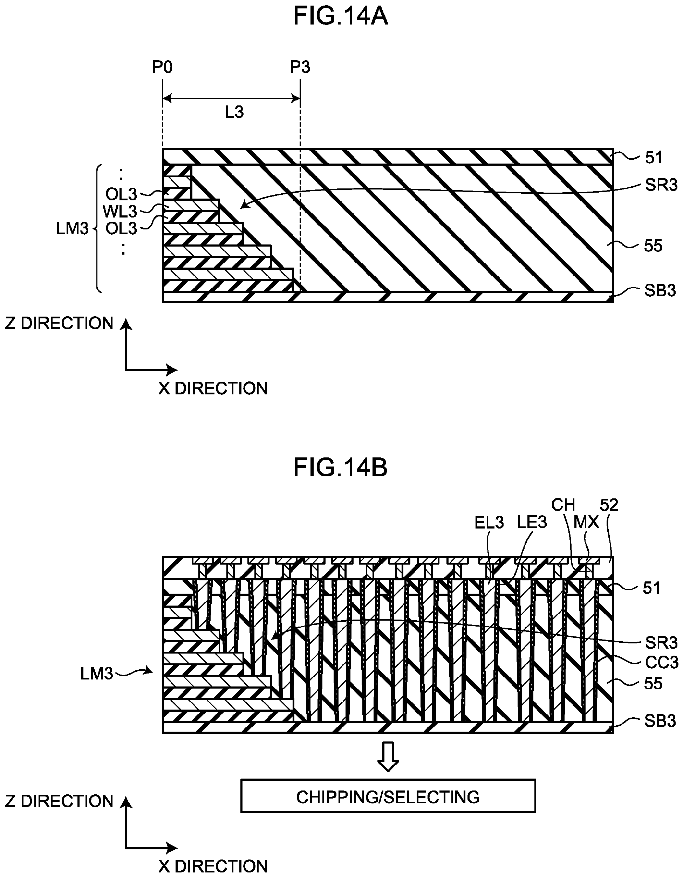

Next, a stage for formation of contacts CC3 is illustrated in Figs. 14A and 14B. Figs. 14A and 14B each illustrate a cross section along the X direction of a portion to be a step region ER on the substrate SB3.

In a region to be a step region ER on the substrate SB3, the stacked body LMs3 is formed and additionally a step portion SR3 is formed due to processing corresponding to the respective pieces of processing for the step portions SR1 and SR2. Next, an insulating layer 55, which reaches the height of the uppermost insulating layer OL3, is formed on the substrate SB3 and the step portion SR3, and then a plurality of word lines WL3 is formed by replacement processing as illustrated in Fig. 14A.

Note that Fig. 14A illustrate a state before an insulating layer 52, plugs CH, bit lines BL, upper layer wiring MX, and the like are formed by the above-described processing in Fig. 13B.

The step portion SR3 is formed to have terrace faces disposed between a position P3 at a distance L3 in the X direction from a predetermined criterial point P0 of the stacked body LMs3 and the criterial point P0. The criterial point P0 is set similarly in position to the respective criterial points P0 set to the above-described stacked bodies LMs1 and LMs2, and the position P3 is set similarly in position to the position P3 set to the above-described stacked body LMs2. In addition, the steps of the step portion SR3 go upward from the position P3 to the criterial point P0. Thus, in a case where the stacked body LM2 and the stacked body LM3 are bonded together such that their criterial points P0 are overlapped on top of each other, the step portion SR2 and the step portion SR3 are continuous stepwise in the X direction.

Next, a plurality of contact holes, which penetrates through the insulating layer 55 and each reaches an individual word line WL1 or the substrate SB3, is formed. An insulating layer LE3 and a conductive layer EL3 are formed in each of the plurality of contact holes. Then, as illustrated in Fig. 14B, contacts CC3 are formed.

In parallel with the above-described processing in Fig. 13B, regarding the step portion SR3, the insulating layer 52 is formed on the insulating layer 51, and plugs CH, which extend in the Z direction in the insulating layer 52 and are connected one-to-one to the conductive layers EL3 of the contacts CC3, are formed. Upper layer wiring MX, which is connected to the contacts CC3 through the plugs CH, is formed.

Next, the substrate SB3 is polished from below until the lowermost insulating layer OL3 is exposed, and then cutting in the Z direction is performed along the division lines. Thus, n chips are formed.

Next, based on the result of test of the memory holes MHA3 output in the test step in Fig. 13A, a chip including a "passed" shot is selected from the n chips. Then, the third step terminates.

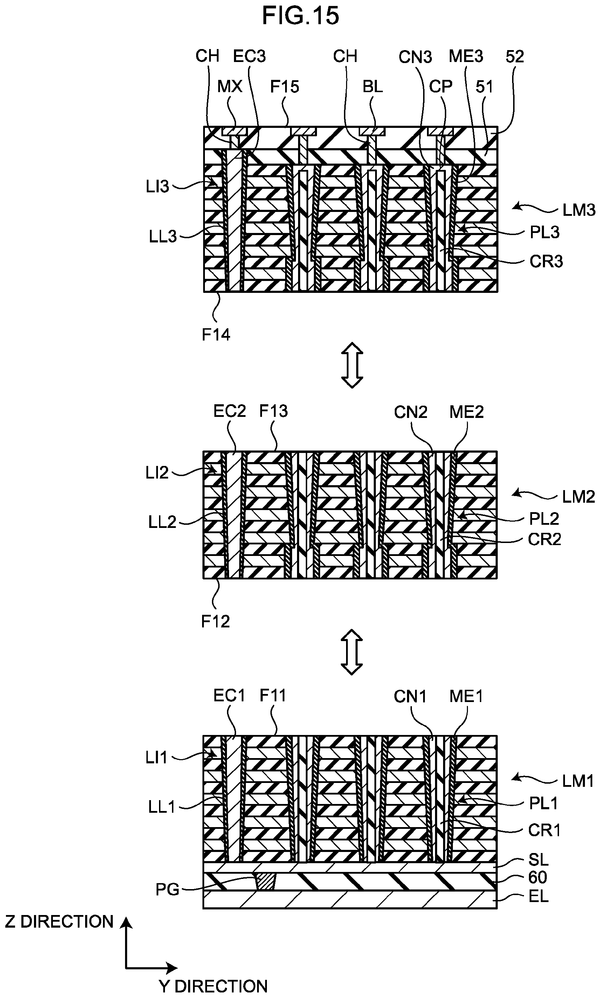

Next, a stage where respective chips selected in the first to third steps are bonded together is illustrated in Fig. 15. Fig. 15 illustrates a cross section along the X direction of portions to be a memory region MR. The bonding step illustrated in Fig. 15 is performed as part of the process of manufacturing the semiconductor device 1.

Here, although the illustration is omitted, the upper surface F15 of the stacked body LM3 as a chip is bonded to a semiconductor substrate SB including a plurality of peripheral circuits CBA corresponding one-to-one to a plurality of shots provided to the semiconductor substrate SB.

For example, an insulating layer 40 that covers the upper surface F15 of the stacked body LM3 and the peripheral circuit CBA (refer to Fig. 1A) is activated in advance, for example, by plasma processing, so that the stacked body LM3 and the peripheral circuit CBA can be joined together. Thus, the stacked body LM3 and the peripheral circuit CBA are electrically connected together.

Next, as illustrated in Fig. 15, the lower surface F14 of the stacked body LM3 and the upper surface F13 of the selected stacked body LM2 cut out from the substrate SB2 are bonded together.

For example, the upper surface F13 of the stacked body LM2 and the lower surface F14 of the stacked body LM3 are activated in advance by plasma processing, so that the stacked body LM2 and the stacked body LM3 can be joined together. In addition, the stacked body LM2 and the stacked body LM3 are joined such that the pillars PL2, the plate-like portion LI2, and the contacts CC2 not illustrated formed in the stacked body LM2 are aligned, respectively, with the pillars PL3, the plate-like portion LI3, and the contacts CC3 not illustrated formed in the stacked body LM3 in the Z direction.

After the stacked body LM2 and the stacked body LM3 are bonded together, annealing is performed. Thus, an electrical connection between each pillar PL2 and the corresponding pillar PL3, an electrical connection between the plate-like portions LI2 and LI3, and an electrical connection between each contact CC2 and the corresponding contact CC3 are made.

Next, similarly, the lower surface F12 of the stacked body LM2 and the upper surface F11 of the stacked body LM1 are bonded together.

Next, the substrate SB1 and the insulating layer 60 are polished from the bottom of the substrate SB1 to a predetermined position of the insulating layer 60, for example, by chemical mechanical polishing (CMP), and furthermore a plug PG, which penetrates through the insulating layer 60 and reaches the source line SL, is formed. In this case, as necessary, an additional insulating layer 60 may be stacked. Next, an electrode film EL is formed lower in position than the plug PG.

Then, the manufacture of the semiconductor device 1 terminates.

### Summary

Conventionally, along with miniaturization of semiconductor devices, an increase in the number of stacked word lines and arrangement of more pillar patterns are desired in order to form more memory cells in a predetermined region of a semiconductor device. In response to an increase in the number of stacked word lines and an increase in the density of pillar patterns, a reduction may be made in the diameter of each individual pillar pattern and a pillar pattern and another pillar pattern may be made close. A reduction in the diameter of a pillar pattern with an increase in the number of stacked word lines may cause, for example, defective pattern bottom removal at the time of etching. Such defective pattern bottom removal occurs conspicuously in response to an increase in the number of stacked word lines, namely, an increase in the aspect ratio of a pillar pattern. In a case where a pillar pattern is disposed close to another pillar pattern, a short circuit may be made between the pillar patterns.

According to one embodiment, a semiconductor device 1 includes a stacked body LM1, a pillar PL1 extending in a Z direction in the stacked body LM1, a stacked body LM2, a pillar PL2 extending in the Z direction in the stacked body LM2, and a bonding surface SP1 interposed between the pillar PL1 and the pillar PL2. The pillar PL1 and the pillar PL2 are connected through the bonding surface SP1 in the Z direction.

As above, the respective pillars PL1 and PL2 formed in the different stacked bodies are connected in the Z direction, so that a pillar PL having a high aspect ratio can be easily formed.

In the semiconductor device 1 according to the embodiment, the pillar PL2 includes an extending portion PE2 extending in the Z direction in the stacked body LM2 and a joint portion PJ1 that is connected to the lower end of the extending portion PE2 through a face SE1 and is connected to the upper end of the pillar PL1 through a face SE2. The diameter of the joint portion PJ1 is not less than the diameter of the lower end of the extending portion PE2 and is not more than the diameter of the upper end of the extending portion PE2.

As above, the diameter D2 of the joint portion PJ1 is not less than the diameter D1 of the lower end of the extending portion PE2, so that a wide allowable range can be ensured for misalignment of connection of the pillar PL2 to the upper end of the pillar PL1. In addition, the diameter D2 of the joint portion PJ1 is not more than the diameter D3 of the upper end of the extending portion PE2, so that such pillars PL2 can be formed more close and additionally adjacent pillars PL2 can be inhibited from being in contact with each other through their joint portions PJ1.

In a method of manufacturing the semiconductor device 1 according to the embodiment, when a substrate SB1 is chipped, a plurality of stacked bodies LM1 is tested and then a stacked body LM1 that has passed the test is selected. When a substrate SB2 is chipped, a plurality of stacked bodies LM2 is tested and then a stacked body LM2 that has passed the test is selected. The selected stacked body LM1 and the selected stacked body LM2 are bonded together.

Since the stacked bodies LM1 and LM2 that have passed the test are bonded together, defective formation of pillars PL can be reduced. For example, a pillar PL is formed in a collective manner, instead of by bonding such stacked bodies LM1 and LM2 together. In a case where either the formation of a portion corresponding to a pillar PL1 or the formation of a portion corresponding to a pillar PL2 is defective, the entire pillar PL is determined as defective. However, such selected stacked bodies are bonded together, so that an improvement can be made in the yield of the semiconductor device 1.

### First Modification

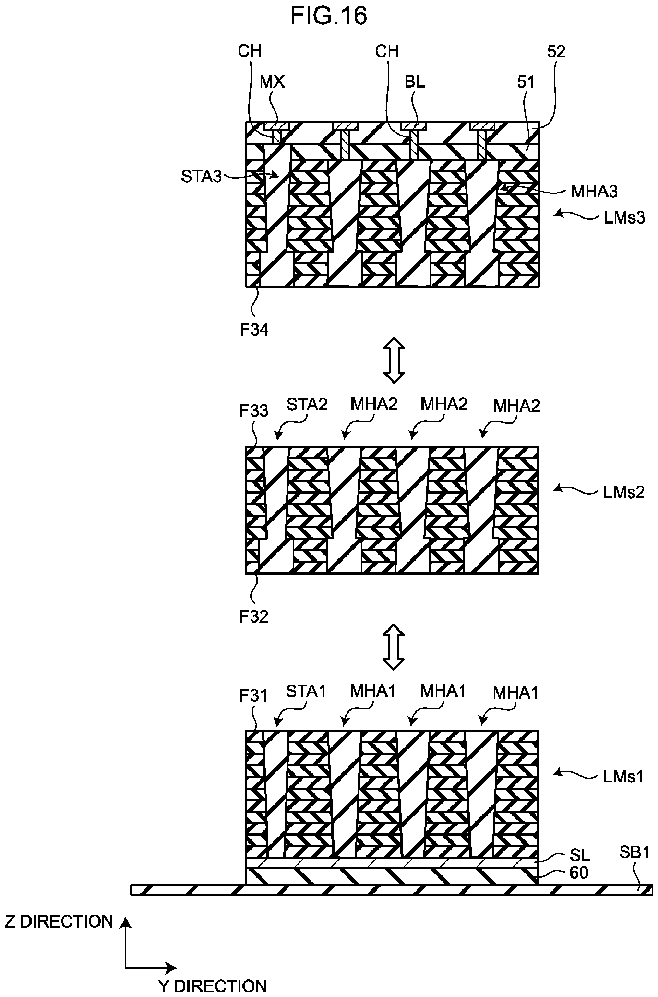

Figs. 16 to 17B each exemplify part of the procedure of a method of manufacturing a semiconductor device according to a first modification. The timing of bonding of stacked bodies in the method of manufacturing the semiconductor device according to the first modification is different from that in the above-described embodiment. Note that, in the following first modification, for simplification of description, the procedure of a method of manufacturing a portion to be a memory region MR will be mainly described. In addition, in the following, constituents similar to those in the above-described embodiment are denoted with similar reference signs and descriptions thereof may be omitted.

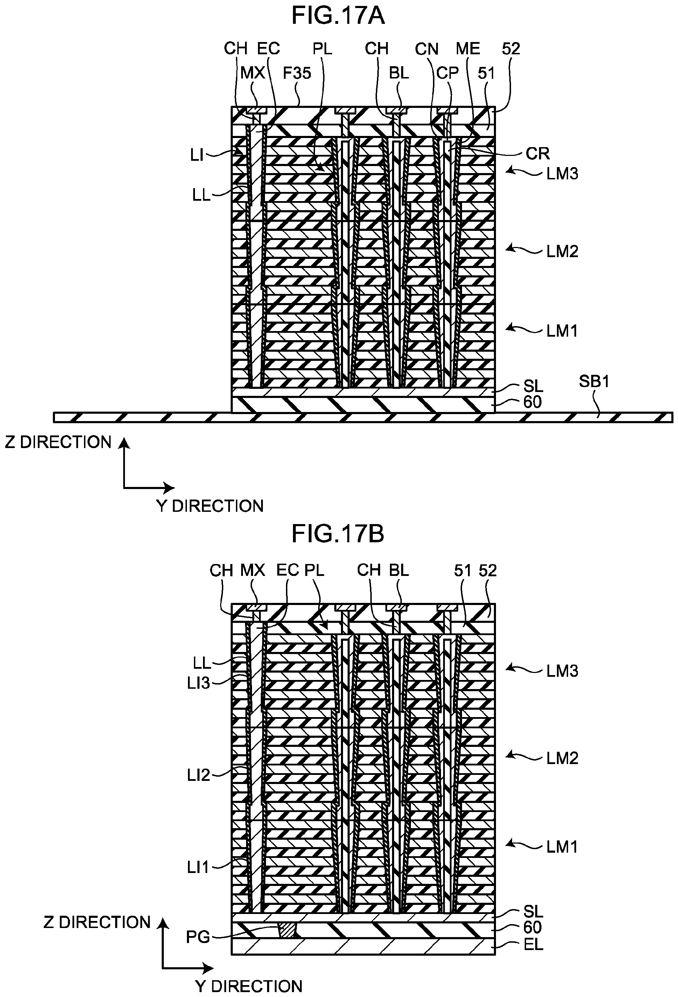

Fig. 16 and Figs. 17A and 17B each illustrate a cross section along an X direction of the portion to be a memory region MR.

First, an insulating layer 60, a source line SL, and a stacked body LMs1 are formed on a substrate SB1 and then memory holes MHA1 are formed. Next, a slit STA1 is formed. After a test step for the memory holes MHA1, the memory holes MHA1 and the slit STA1 each have a CVD carbon layer or the like embedded therein.

Next, a stacked body LMs2 and memory holes MHA2 are formed on a substrate SB2. Next, after a test step for the memory holes MHA2, a slit STA2 is formed. Then, the memory holes MHA2 and the slit STA2 each have a CVD carbon layer or the like embedded therein. Chipping per stacked body LMs2 is performed.

Next, a stacked body LMs3 and memory holes MHA3 are formed on a substrate SB3. Next, after a test step for the memory holes MHA3, a slit STA3 is formed. Then, the memory holes MHA3 and the slit STA3 each have a CVD carbon layer or the like embedded therein. In addition, an insulating layer 52 is formed on an insulating layer 51 and then plugs CH, bit lines BL, and upper layer wiring MX are formed. Chipping per stacked body LMs3 is performed.

Next, as illustrated in Fig. 16, the upper surface F31 of the stacked body LMs1 and the lower surface F32 of the stacked body LMs2 are bonded together, and the upper surface F33 of the stacked body LMs2 and the lower surface F34 of the stacked body LMs3 are bonded together. That is, in the first modification, a chip of substrate SB2 and a chip of substrate SB3 after chipping are bonded onto the substrate SB1 not yet chipped. Note that the substrate SB2 having the stacked body LMs2 thereon is removed, for example, by CMP when the stacked body LMs2 is bonded to the stacked body LMs1, and the substrate SB3 having the stacked body LMs3 thereon is removed, for example, by CMP when the stacked body LMs3 is bonded to the stacked body LMs2. As stacked bodies LMs2 and LMs3 to be bonded to a stacked body LMs1, only stacked bodies LMs2 and LMs3 of passed chips are used. In addition, such stacked bodies LMs2 and LMs3 are bonded to only a stacked body LMs1 that has passed the test.

Next, as illustrated in Fig. 17A, after removal of the CVD carbon layer or the like, a memory film ME, a channel layer CN, a core layer CR, and a cap layer CP are formed to each set of the memory holes MHA 1 to MHA3 to form pillars PL. Next, stacked bodies LM1 to LM3 are formed by replacement processing. A liner layer LL and a conductive portion EC are filled between the side walls of the slits STA1 to STA3 to form a plate-like contact LI.

Next, although the illustration is omitted, a semiconductor substrate SB including a peripheral circuit CBA is bonded to the upper surface F35 of the stacked body LM3. The substrate SB1 having the stacked body LM1 thereon is removed, for example, by CMP. Then, as illustrated in Fig. 17B, a plug PG, which penetrates through the insulating layer 60, and an electrode film EL are formed under the source line SL. Then, the semiconductor substrate SB is chipped for each set of the stacked bodies LM1 to LM3 and the peripheral circuit CBA.

Then, the semiconductor device according to the first modification is manufactured.

The semiconductor device and the method of manufacturing the semiconductor device according to the first modification have effects similar to those according to the above-described embodiment.

### Second Modification

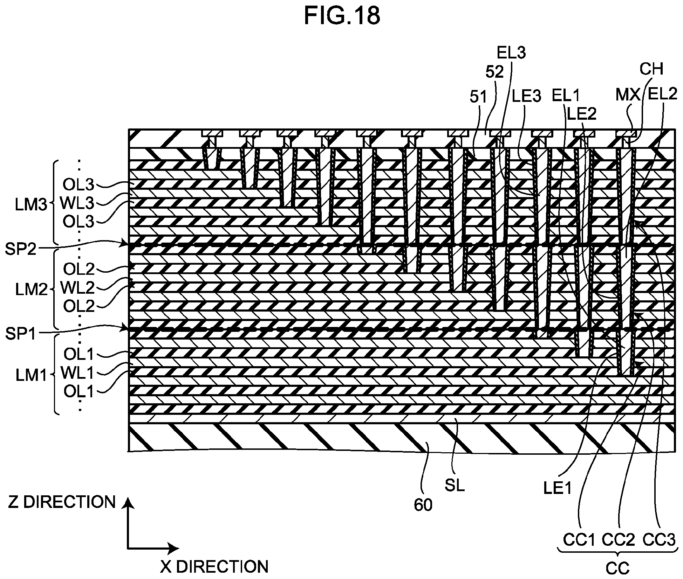

Next, a second modification will be described with Fig. 18. A semiconductor device according to the second modification has a step region ER different in configuration from that according to the above-described embodiment.

Fig. 18 illustrates an exemplary detailed configuration of the step region ER according to the second modification. In more detail, Fig. 18 is a sectional view along an X direction of the step region ER and corresponds to Fig. 3A. Note that, referring to Fig. 18, the structure above an insulating layer 52 and the structure below an insulating layer 60 are omitted. In addition, in the following, constituents similar to those in the above-described embodiment and first modification are denoted with similar reference signs and descriptions thereof may be omitted.

As illustrated in Fig. 18, a stacked body LM1 has an end, in the X direction, in which a plurality of contacts CC1 is formed. The plurality of contacts CC1 extends in a Z direction in the stacked body LM1. That is, no step portion SR1 (refer to Fig. 3A) is formed in the stacked body LM1. The contacts CC1 each have a lower end that reaches a word line WL1 included in the stacked body LM1 and have an upper end that reaches a bonding surface SP1. When viewed from the side of location of the end in the X direction of the stacked body LM1, a gradual reduction is made in the depths of the lower ends of the contacts CC1.

A stacked body LM2 has an end, in the X direction, in which a plurality of contacts CC2 is formed. The contacts CC2 extend in the Z direction in the stacked body LM2. That is, no step portion SR2 (refer to Fig. 3A) is formed in the stacked body LM2. Some of the contacts CC2 individually have a lower end that reaches a word line WL2 included in the stacked body LM2 and have an upper end that reaches a bonding surface SP2. When viewed from the side of location of the end in the X direction of the stacked body LM2, a gradual reduction is made in the depths of the lower ends of the contacts CC2. In addition, the others of the contacts CC2 individually have a lower end connected to the corresponding contact CC1 through the bonding surface SP1 in the Z direction and have an upper end that reaches the bonding surface SP2.

A stacked body LM3 has an end, in the X direction, in which a plurality of contacts CC3 is formed. The contacts CC3 extend in the Z direction in the stacked body LM3. That is, no step portion SR3 (refer to Fig. 3A) is formed in the stacked body LM3. Some of the contacts CC3 individually have a lower end that reaches a word line WL3 included in the stacked body LM3 and have an upper end that penetrates through an insulating layer 51 and reaches the insulating layer 52. When viewed from the side of location of the end in the X direction of the stacked body LM3, a gradual reduction is made in the depths of the lower ends of the contacts CC3. In addition, the others of the contacts CC3 individually have a lower end connected to the corresponding contact CC2 through the bonding surface SP2 and have an upper end that penetrates through the insulating layer 51 and reaches the insulating layer 52.

Contacts CC, which gradually reduce in depth from the side of location of the end in the X direction, are each formed due to mutual connection of the contacts CC1 to CC3 as above. Note that, although the illustration is omitted, the semiconductor device according to the second modification may include constituents corresponding to the joint portion CJ1 and the extending portion CE1 in the embodiment.

In addition, although the illustration is omitted, the semiconductor device according to the second modification is manufactured through first to third steps and a bonding step similar to those in the embodiment.

In the first step of forming contacts CC1, after a stacked body LMs1 is formed, a mask pattern having a plurality of openings is formed on the upper surface of the stacked body LMs1. The mask pattern is, for example, an oxidized silicon layer. Next, a resist pattern covering part of the mask pattern is formed and then the stacked body LMs1 is etched through the mask pattern exposed from the resist pattern. After that, the resist pattern is subjected to slimming and etching is repeated while the openings of the mask pattern are gradually exposed from the side of location of an end in the X direction. Thus, contact holes, which gradually reduce in depth from the side of location of the end in the X direction, are formed. Next, replacement processing is performed, and then the contact holes are each filled with an insulating layer LE1 and a conductive layer EL1. Then, contacts CC1 are formed. After that, a passed chip is selected, and then the first step terminates.

In the second step, contacts CC2 are formed through steps corresponding to those in the first step. In the third step, contacts CC3 are formed through steps corresponding to those in the first step. After that, for example, through the bonding step, the manufacture of the semiconductor device according to the second modification terminates.

The semiconductor device and the method of manufacturing the semiconductor device according to the second modification have effects similar to those in the above-described embodiment and first modification.

### Other Modifications

In each of the above-described embodiment and modifications, the shapes of the memory holes MHA1 to MHA3 as targets are tested in the test step. However, test targets are not limited to the memory holes MHA1 to MHA3. For example, the contact holes HLc, the slits STA1 to STA3, or the pillars PL1 to PL3 each having the memory film ME, the channel layer CN, and the core layer CR formed therein may be selected as test targets.

In each of the above-described embodiment and modifications, the pillars PL2 each have the joint portion PJ1 formed at its lower end and the pillars PL3 each have the joint portion PJ2 formed at its lower end, whereas the contacts CC1 each have the joint portion CJ1 formed at its upper end and the contacts CC2 each have the joint portion CJ2 formed at its upper end. However, the position of formation of a joint portion is not limited to the above. For example, the pillars PL1 may each have the joint portion PJ1 formed at its upper end and the pillars PL2 may each have the joint portion PJ2 formed at its upper end. The contacts CC2 may each have the joint portion CJ1 formed at its lower end and the contacts CC3 may each have the joint portion CJ2 formed at its lower end. For example, in a case where a sufficient accuracy of alignment is obtained for joining between the stacked bodies LM1 to LM3, the pillars PL2 may each have no joint portion PJ1 and the pillars PL3 may each have no joint portion PJ2. In addition, the contacts CC2 may each have no joint portion CJ1 and the contacts CC3 may each have no joint portion CJ2.

In each of the above-described embodiment and modifications, the stacked bodies LM1 to LM3 are formed, respectively, on the substrates SB1 to SB3. However, the stacked bodies LM1 to LM3 are not necessarily distinguished. For example, stacked bodies identical in structure may be formed on a plurality of substrates. Alternatively, stacked bodies identical in structure may be formed on a single substrate. After that, such substrates are chipped and then passed chips are selected from the chips. Then, in accordance with any of the respective procedures in the embodiment and the first and second modifications, the passed chips are bonded, in order, to a substrate SB on which a peripheral circuit CBA is formed. In this case, for example, bit lines BL, upper layer wiring MX, and plugs CH can be formed in advance on the side of location of the peripheral circuit CBA. After bonding to the peripheral circuit CBA, a source line SL, an insulating layer 60, a plug PG, and an electrode film EL are formed on a face that a stacked body LM has opposite to its another face bonded to the peripheral circuit CBA, so that a semiconductor device 1 similar, for example, to that in the above-described embodiment can be obtained.

In each of the above-described embodiment and modifications, the semiconductor device 1 includes three stacked bodies LM1 to LM3. However, the number of stacked bodies included in the semiconductor device 1 may be two or four or more.

In each of the above-described embodiment and modifications, pillars and the like are formed with the substrates SB1 to SB3 at least any of which is not yet chipped. However, for example, before pillars and the like are formed, the substrates SB1 to SB3 may be each chipped and then the pillars and the like may be formed to chips of substrates SB1 to SB3 secured onto a substrate that is different from the substrates SB1 to SB3 and is not yet chipped.

In each of the above-described embodiment and modifications, a case where a three-dimensional nonvolatile memory is formed as the semiconductor device 1 is given. However, a target to which the present invention is applied is not limited to such a three-dimensional nonvolatile memory. The present invention can be applied to other semiconductor devices each having a structure high in aspect ratio. For example, the present invention may be applied to a volatile memory, such as dynamic random access memory (DRAM).

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A semiconductor device (1) comprising:
a first structure (LM1);
a first columnar body (PL1, CC1) extending in a first direction in the first structure (LM1);
a second structure (LM2);
a second columnar body (PL2, CC2) extending in the first direction in the second structure (LM2); and
a bonding surface (SP1) interposed between the first structure (LM1) and the second structure (LM2), wherein
the first columnar body (PL1, CC1) and the second columnar body (PL2, CC2) are connected through the bonding surface (SP1) in the first direction.

2. The semiconductor device (1) according to claim 1, wherein
the first structure (LM1) is configured as a first stacked body (LM1) including a plurality of first conductive layers (WL1) and a plurality of first insulating layers (OL1) alternately stacked,
the first columnar body (PL1, CC1) is configured as a first pillar (PL1) including a first semiconductor layer (CN1) extending in the first direction in the first stacked body (LM1),
the second structure (LM2) is configured as a second stacked body (LM2) including a plurality of second conductive layers (WL2) and a plurality of second insulating layers (OL2) alternately stacked, and
the second columnar body (PL2, CC2) is configured as a second pillar (PL2) including a second semiconductor layer (CN2) extending in the first direction in the second stacked body (LM2).

3. The semiconductor device (1) according to claim 2, wherein
the second pillar (PL2) includes:
an extending portion (PE1) extending in the first direction in the second stacked body (LM2); and
a joint portion (PJ1) connected to an end closer to the bonding surface (SP1) of the extending portion (PE1) through a first surface (SE1), the joint portion (PJ1) being connected to an end closer to the bonding surface (SP1) of the first pillar (PL1) through a second surface (SE2), and
the joint portion (PJ1) having a diameter that is not less than a diameter of the end closer to the bonding surface (SP1) of the extending portion (PE1) and is not more than a diameter of another end of the extending portion (PE1).

4. The semiconductor device (1) according to claim 1, wherein
the first structure (LM1) is configured as a first stacked body (LM1) including a plurality of first conductive layers (WL1) and a plurality of first insulating layers (OL1) alternately stacked, the first stacked body (LM1) including a first step portion (SR1) in which the plurality of first conductive layers (WL1) is processed stepwise extending in a second direction crossing the first direction,
the first step portion (SR1) is covered with a third insulating layer (53),
the first columnar body (PL1, CC1) is configured as a first contact (CC1) extending in the first direction in the third insulating layer (53), the first contact (CC1) being connected to one first conductive layer (WL1) of the plurality of first conductive layers (WL1) processed stepwise,
the second structure (LM2) is configured as a second stacked body (LM2) including a plurality of second conductive layers (WL2) and a plurality of second insulating layers (OL2) alternately stacked, the second stacked body (LM2) including a second step portion (SR2) in which the plurality of second conductive layers (WL2) is processed stepwise continuous with the first step portion (SR1) in the second direction,
the second step portion (SR2) is covered with a fourth insulating layer (54), and
the second columnar body (PL2, CC2) is configured as a second contact (CC2) extending in the first direction in the fourth insulating layer (54), the second contact (CC2) being connected to one second conductive layer (WL2) of the plurality of second conductive layers (WL2) processed stepwise.

5. The semiconductor device (1) according to claim 4, wherein
the first contact (CC1) and the second contact (CC2) each include a conductive portion (EL1, EL2) including a conductive substance, and
a diameter of the conductive portion (EL1, EL2) on the bonding surface (SP1) of the first contact (CC1) is larger than a diameter of the conductive portion (EL1, EL2) on the bonding surface (SP1) of the second contact (CC2).

6. The semiconductor device (1) according to claim 1, wherein
the first structure (LM1) is configured as a first stacked body (LM1) including a plurality of first conductive layers (WL1) and a plurality of first insulating layers (OL1) alternately stacked,
the first columnar body (PL1, CC1) is configured as a first contact (CC1) extending in the first direction in the first stacked body (LM1), the first contact (CC1) having a lower end at a depth that gradually decreases as the lower end is distanced from an end of the first stacked body (LM1), the lower end being connected to one of the plurality of first conductive layers (WL1),
the second structure (LM2) is configured as a second stacked body (LM2) including a plurality of second conductive layers (WL2) and a plurality of second insulating layers (OL2) alternately stacked, and
the second columnar body (PL2, CC2) is configured as a second contact (CC2) extending in the first direction in the second stacked body (LM2), the second contact (CC2) having a lower end at a depth that gradually decreases as the lower end is distanced from an end of the second stacked body (LM2), the lower end being connected to one of the plurality of second conductive layers (WL2).

7. The semiconductor device (1) according to claim 6, wherein
the first contact (CC1) and the second contact (CC2) each include a conductive portion (EL1, EL2) including a conductive substance.

8. The semiconductor device (1) according to claim 2, further comprising:
a first plate-like portion (LI1) extending in the first direction and in a second direction crossing the first direction in the first structure (LM1); and
a second plate-like portion (LI2) extending in the first direction and in the second direction in the second structure (LM2), wherein
the first plate-like portion (LI1) and the second plate-like portion (LI2) are connected through the bonding surface (SP1) in the first direction.

9. The semiconductor device (1) according to claim 8, wherein
the first plate-like portion (LI1) and the second plate-like portion (LI2) each include a conductive portion (EL1, EL2) including a conductive substance.

10. A method of manufacturing a semiconductor device (1), the method comprising:
forming, on a first substrate (SB1), a first structure (LM1) and a first columnar body (PL1, CC1) extending in a first direction in the first structure (LM1);
forming, on a second substrate (SB2), a second structure (LM2) and a second columnar body (PL2, CC2) extending in the first direction in the second structure (LM2); and
bonding the first structure (LM1) and the second structure (LM2) through a bonding surface (SP1) including a first surface (SE1) crossing the first structure (LM1) in the first direction and a second surface (SE2) crossing the second structure (LM2) in the first direction such that the first columnar body (PL1, CC1) and the second columnar body (PL2, CC2) are connected in the first direction.

11. The method according to claim 10, wherein
the forming the first structure (LM1) and the first columnar body (PL1, CC1) includes:
forming a plurality of first structures (LM1) including the first structure (LM1); and
forming a plurality of first columnar bodies (PL1, CC1) including the first columnar body (PL1, CC1) one-to-one in the plurality of first structures (LM1),
the forming the second structure (LM2) and the second columnar body (PL2, CC2) includes:
forming a plurality of second structures (LM2) including the second structure (LM2); and
forming a plurality of second columnar bodies (PL2, CC2) including the second columnar body (PL2, CC2) one-to-one in the plurality of second structures (LM2), and
the method further comprises, before the bonding the first structure (LM1) and the second structure (LM2):
chipping the first substrate (SB1) for each of the plurality of first structures (LM1); and
chipping the second substrate (SB2) for each of the plurality of second structures (LM2).

12. The method according to claim 11, wherein
the bonding the first structure (LM1) and the second structure (LM2) includes:
testing the plurality of first structures (LM1) to select a first structure (LM1) that has passed the test;
testing the plurality of second structures (LM2) to the select a second structure (LM2) that has passed the test; and
bonding the first substrate (SB1) including the selected first structure (LM1) and the second substrate (SB2) including the selected second structure (LM2).

13. The method according to claim 10, wherein
the first structure (LM1) is configured as a first stacked body (LM1) including a plurality of first conductive layers (WL1) and a plurality of first insulating layers (OL1) alternately stacked,
the first columnar body (PL1, CC1) is configured as a first pillar (PL1) including a first semiconductor layer (CN1) extending in the first direction in the first stacked body (LM1),
the second structure (LM2) is configured as a second stacked body (LM2) including a plurality of second conductive layers (WL2) and a plurality of second insulating layers (OL2) alternately stacked, and
the second columnar body (PL2, CC2) is configured as a second pillar (PL2) including a second semiconductor layer (CN2) extending in the first direction in the second stacked body (LM2).

14. The method according to claim 10, wherein
the first structure (LM1) is configured as a first stacked body (LM1) including a plurality of first conductive layers (WL1) and a plurality of first insulating layers (OL1) alternately stacked, the first stacked body (LM1) including a first step portion (SR1) in which the plurality of first conductive layers (WL1) is processed stepwise extending in a second direction crossing the first direction,
the first step portion (SR1) is covered with a third insulating layer (53),
the first columnar body (PL1, CC1) is configured as a first contact (CC1) extending in the first direction in the third insulating layer (53), the first contact (CC1) being connected to one first conductive layer (WL1) of the plurality of first conductive layers (WL1) processed stepwise,
the second structure (LM2) is configured as a second stacked body (LM2) including a plurality of second conductive layers (WL2) and a plurality of second insulating layers (OL2) alternately stacked, the second stacked body (LM2) including a second step portion (SR2) in which the plurality of second conductive layers (WL2) is processed stepwise continuous with the first step portion (SR1) in the second direction,
the second step portion (SR2) is covered with a fourth insulating layer (54), and
the second columnar body (PL2, CC2) is configured as a second contact (CC2) extending in the first direction in the fourth insulating layer (54), the second contact (CC2) being connected to one second conductive layer (WL2) of the plurality of second conductive layers (WL2) processed stepwise.

15. The method according to claim 10, wherein
the first structure (LM1) is configured as a first stacked body (LM1) including a plurality of first conductive layers (WL1) and a plurality of first insulating layers (OL1) alternately stacked,
the first columnar body (PL1, CC1) is configured as a first contact (CC1) extending in the first direction in the first stacked body (LM1), the first contact (CC1) having a lower end at a depth that gradually decreases as the lower end is distanced from an end of the first stacked body (LM1), the lower end being connected to one of the plurality of first conductive layers (WL1),
the second structure (LM2) is configured as a second stacked body (LM2) including a plurality of second conductive layers (WL2) and a plurality of second insulating layers (OL2) alternately stacked, and
the second columnar body (PL2, CC2) is configured as a second contact (CC2) extending in the first direction in the second stacked body (LM2), the second contact (CC2) having a lower end at a depth that gradually decreases as the lower end is distanced from an end of the second stacked body (LM2), the lower end being connected to one of the plurality of second conductive layers (WL2).
